Europäisches Patentamt

(19) European Patent Office (11) Publication number: **0 028 655**

Office européen des brevets **B1**

(12) **EUROPEAN PATENT SPECIFICATION**

(45) Date of publication of patent specification: **25.07.84** (51) Int. Cl.³: **H 01 L 21/22, H 01 L 21/31, H 01 L 29/70, H 01 L 21/72**

(21) Application number: **80900915.2**

(22) Date of filing: **17.05.80**

(86) International application number: **PCT/JP80/00107**

(87) International publication number: **WO 80/02623 27.11.80 Gazette 80/27**

(54) **METHOD OF FABRICATING SEMICONDUCTOR DEVICE.**

(30) Priority: **18.05.79 JP 61232/79**

(43) Date of publication of application: **20.05.81 Bulletin 81/20**

(45) Publication of the grant of the patent: **25.07.84 Bulletin 84/30**

(84) Designated Contracting States: **DE FR GB NL**

(56) References cited:
**JP - A - 51 040 773**
**JP - B - 49 047 992**
**JP - B - 51 004 069**
**US - A - 4 005 453**
**US - A - 4 016 594**
**US - A - 4 067 037**

(73) Proprietor: **FUJITSU LIMITED**
**1015, Kamikodanaka Nakahara-ku**
**Kawasaki-shi Kanagawa 211 (JP)**

(72) Inventor: **FUKUDA, Takeshi**
**41-6, Higashita-magawa, 2-chome**
**Setagaya-ku Tokyo 158 (JP)**
Inventor: **ICHINOSE, Yoshito**
**465, Suwa Takatsu-ku**
**Kawasaki-shi Kanagawa 213 (JP)**

(74) Representative: **Allman, Peter John et al,**
**Marks and Clerk Scottish Life House Bridge Street**
**Manchester M3 3DP (GB)**

Courier Press, Leamington Spa, England.

# Description

The present invention relates to a process for producing a semiconductor device, more particularly, a process including the step of introducing boron impurities into a semiconductor body in a self alignment process utilizing a silicon nitride film.

According to a known production process of a semiconductor device, a silicon nitride film is preliminarily selectively removed so that the thus formed windows in the silicon nitride film conform to the dimensions of predetermined elements of the semiconductor device. Subsequently, impurities including boron are introduced through the windows onto the semiconductor body surface so as to form these elements in self alignment with the windows in the silicon nitride film. Various structures, for example an iso-planar structure, produced by self alignment have been invented for the purpose of reducing the size of a semiconductor element to as small as possible and, hence, increasing the integration degree of integrated circuits. The defining borders of a film including the silicon nitride film, are hereinafter referred to as patterning. In the production of a bipolar transistor utilizing self alignment, a silicon nitride film is patterned so as to form windows exposing a silicon dioxide film beneath the silicon nitride film, and further windows exposing the isolation region, the base region and the collector contact region of a silicon layer are successively formed beneath the windows in the silicon nitride film through the silicon dioxide film, using the silicon nitride film as a mask. Thereafter boron impurities are diffused through each window. The windows through the silicon nitride film exposing the silicon dioxide film are formed simultaneously so as to prevent the deviation of the positions of the three regions mentioned above from the theoretical desired positions.

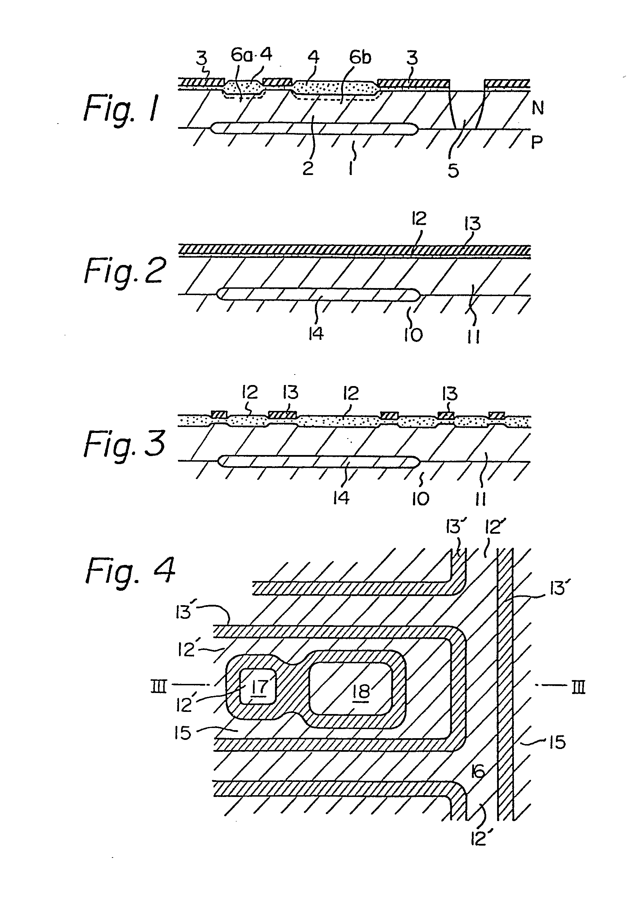

One step which is made when producing a bipolar transistor utilizing self alignment is illustrated in Figure 1, wherein an isolation region is formed in the NPN bipolar transistor utilizing the conventional self alignment method. In Figure 1, an N type epitaxial layer (2) is placed on a P type semiconductor substrate (1), and a silicon nitride film (3) is patterned as illustrated in Figure 1. A silicon dioxide film (4) is formed on the portions of the N type epitaxial layer (2) not covered by the silicon nitride film (3) and is then removed from the isolation region (5). The P type isolation region (5) is formed by gas diffusion using boron bromide (BBr₃) as a diffusion source.

It was discovered in experiments conducted by the present inventors that, when boron, which is a commonly used P type impurity, is diffused, boron reacts with the silicon nitride ($Si_3N_4$) film (3) and generates a disadvantageous phenomenon of the adhering of the reaction mixture on the silicon dioxide film and, thus, degrading the silicon dioxide ($SiO_2$) film. The silicon dioxide film (4) masking one region (6a) is degraded during the successive boron diffusion into the isolation region (5) and the region (6b) of the N type epitaxial layer (2), with the result that boron is caused to diffuse into this region (6a) of the N type epitaxial layer (2) and thus may form a P type region. In extreme cases, the resistance of a region, where a high resistance is to be provided, is abnormally decreased.

In recent years, since the dimensions of semiconductor elements, such as bipolar transistors, have become small and, further, the integration degree of semiconductor devices has become high, the surface area of a semiconductor substrate occupied by semiconductor elements is smaller than that occupied by metal conductors which connect the semiconductor elements to each other. Since the metal conductors are formed on the insulating film of the silicon nitride covering the semiconductor substrate, the surface area of the silicon nitride film has beccme larger than that of the semiconductor elements in recent years and is increasing even more with recent increases in the integration degree. Consequently, the phenomenon of degrading of the silicon dioxide film due to a reaction between the boron and the silicon nitride film leads to a reduction in the production recovery and the reliability of the semiconductor devices.

In order to avoid degrading of the silicon dioxide film, measures for protecting the silicon nitride film against reacting with boron have been employed by the applicant, in which the silicon nitride film is covered by a silicon dioxide film which is deposited on the silicon nitride film by a CVC process. However, in these measures a CVC production step is necessary, in addition to the conventional steps of producing the semiconductor devices, and the production cost of the semiconductor devices has, as a result, become high.

A further example of the prior art is described in U.S. Patent No. 3, 963 524 which discloses the patterning of a silicon nitride layer to form first masks, the formation of second masks of silicon dioxide in the areas not covered by the first masks, and finally selective removal of the second masks to dope an impurity into the exposed semiconductor body.

It is an object of the present invention to eliminate harmful influences on the reliability and production recovery of semiconductor devices due to such reaction between boron and a silicon nitride film and to produce semiconductor devices in a self alignment process utilizing the silicon nitride film.

In accordance with the object of the present invention, there is provided a process comprising the steps of:

- forming a silicon nitride film over a semiconductor body;

selectively removing said nitride film so as to form first masks made of nitride, each of which masks is in the form of an endless stripe in a plan view;

masking the semiconductor body not covered by said first masks by second masks of an oxide film, the width in the plan view of the stripe of each said first mask being considerably less than the widths of the second masks;

selectively removing said second masks, thereby exposing said semiconductor body and;

introducing boron impurities into the exposed semiconductor body.

Since, in accordance with the process of the present invention, the mask against the diffusion of boron impurities is realized not only by the first masks made of the nitride but also by the second masks made of oxide film, and further, since the surface area of the first masks is small due to the thin width, i.e. the stripe form, of the first masks, the reaction between boron and silicon nitride at the boron diffusion temperature of approximately 1100°C exerts no harmful influence on the reliability and production recovery of the semiconductor device. The thermal expansion coefficient of silicon nitride, which is a preferable nitride of the first masks, is different from that of a semiconductor body and the Young's modulus of silicon nitride is greater than that of a semiconductor body. Consequently, a crystal defect is liable to be induced in the silicon nitride film and the semiconductor body. The frequency of the occurence of inferior electric characteristics in the semiconductor devices due to the crystal defect is decreased in the present invention as compared to the prior art, in which silicon nitride has been mainly used for the mask against boron diffusion.

In an embodiment of the process of the present invention, the process for producing a semiconductor device is characterized by preliminarily forming an oxide film on a semiconductor body and then forming said nitride film. In this embodiment mentioned above, since the silicon dioxide film remaining on the semiconductor body is used as the second masks, and further, since the silicon dioxide is customarily formed on the semiconductor body prior to the deposition of a silicon nitride film, no additional step is required for the formation of the second masks. It is preferable to increase the thickness of the second masks by heating the second masks made of silicon dioxide in an oxidizing atmosphere of $CO_2$, $O_2$, air, etc., to a temperature of from 900 to 1000°C. When the thickness of the second masks is from 300— 500 nm (3000 to 5000 angstroms), their masking effect against thermally diffused boron is particularly desirable. In the embodiment mentioned above, by the selective removal or patterning of the silicon nitride film, a plurality of windows are simultaneously formed within the first masks and these windows have dimensions corresponding to several regions, e.g. isolation, collector-contact and base regions of a semiconductor device. Accordingly, these regions are formed in self alignment with the patterning of the silicon nitride film.

Instead of forming the silicon nitride film on the silicon dioxide film, the silicon nitride film can be directly formed on the semiconductor body.

Brief explanation of drawings

Figure 1 illustrates a conventional process for producing a semiconductor device and a formation step of an isolation region.

Figures 2 through 7 illustrate a sequence of steps of an embodiment of the process according to the present invention.

Best mode for carrying out the invention

The present invention is explained in detail hereinafter by way of an embodiment for forming an NPN bipolar transistor, with reference to Figures 2 through 7.

As illustrated in Figure 2, an N type epitaxial layer (11) is placed on a p type semiconductor silicon substrate (10). A silicon dioxide ($SiO_2$) film (12) having a thickness of approximately 100 nm (1,000 Å) is formed on the surface of the N type epitaxial layer by a known thermal oxidation, and the upper surface of the silicon dioxide film is covered by a silicon nitride ($Si_3N_4$) film (13) having a thickness of approximately 200 nm (2,000 Å). Reference numeral (14) indicates an N type buried layer which is formed by selectively diffusing N type impurities on the semiconductor silicon substrate (10).

Subsequent to the formation of the silicon nitride film, the silicon nitride ($Si_3N_4$) film (13) is patterned, as illustrated in Figure 3, using a known photolithographic technique. The patterning of the silicon nitride ($Si_3N_4$) film is conventionally carried out, so that the entire semiconductor layer, except for the region in which boron is diffused, is covered by the silicon nitride film. The silicon nitride ($Si_3N_4$) film (13) is patterned as first masks, and each first mask covers the outer periphery of diffusion regions to be exposed within windows and has a width of approximately 4 microns, as illustrated in Figure 4, in which the endless stripe shape of patterned first masks is seen in a plan view. Subsequent to the patterning of the first masks, the silicon of the epitaxial layer (11) is subjected to a high temperature oxidation, so that the thickness of the portions of the silicon dioxide ($SiO_2$) film (12) on which the silicon nitride ($Si_3N_4$) film (13) is not present becomes approximately 300 nm (3,000 Å). The 300 nm (3,000 Å) thick silicon dioxide film portions are used as second masks. The second masks (12′) of the silicon dioxide film covers not only the diffusion regions, which have been conventionally masked by silicon dioxide film, but also, the regions which have conventionally been masked by a silicon nitride ($Si_3N_4$) film.

In Figure 4, a part of the first and second mask pattern is illustrated. Reference numeral (13') indicates the first masks consisting of non removed silicon nitride ($Si_3N_4$) film and reference numeral (12') indicates the second masks consisting of thick silicon dioxide film. It should be noted here that on the surface of the epitaxial layer (11) covered by the second masks (12') the silicon nitride ($Si_3N_4$) film is not removed in the conventional process, but is completely removed in the present invention. A window is formed within each of the plurality of first masks. The inner line of each first mask (the outer peripheral line of the window) defines the outer periphery of the regions explained hereinafter. The cross section of the mask patterns along line III—III is illustrated in Figure 3. Windows (16), (17) and (18) are formed by one patterning of the silicon nitride film and have the dimension of an isolation region, a collector contact region and a diffusion region of a base and an emitter, respectively. These three regions are, therefore, successively formed in self alignment with the patterning of the silicon nitride film.

It is believed that in the design of the first and second mask patterns illustrated in Figure 4, the position of each of the windows (16), (17) and (18) may be deviated in the patterning step by photolithography from the theoretical position by approximately 2 $\mu$m. Even if such deviation occurs, these windows or the three regions mentioned above should not overlap each other. In order to provide the first masks with a width sufficient to prevent overlapping, the width of the first masks is approximately 4 microns, as mentioned above, which is twice the deviation. The first mask width is, therefore, not limited to 4 microns, but may be the minimum value required for ensuring an electric separation of semiconductor substrate regions, from each other, which minimum value is dependent upon the accuracy of patterning by photolithography.

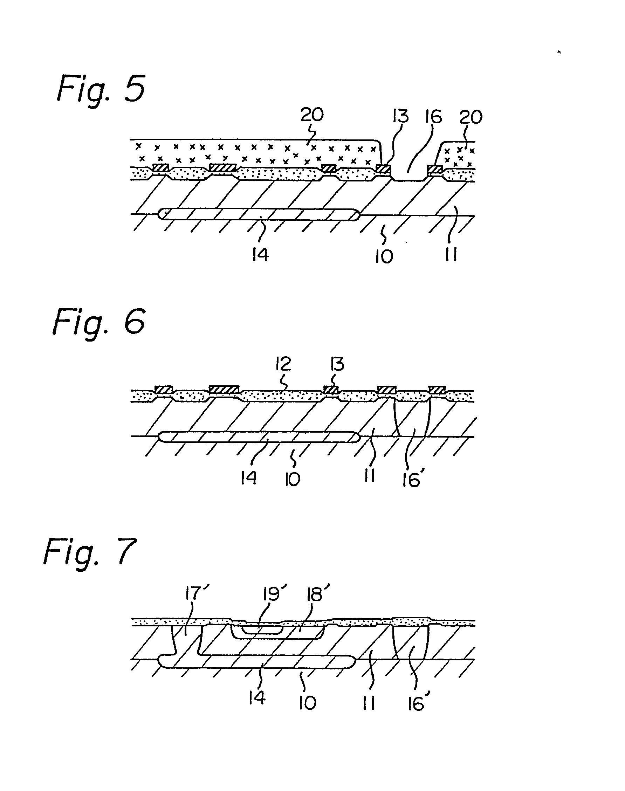

Subsequent to the formation of the first and second masks, a photoresist film (20) is patterned by a photolithographic process as illustrated in Figure 5. The silicon dioxide ($SiO_2$) film (12) within the window (16) for the isolation region is removed by etching using the photoresist film (20) as a mask, so that a window exposing the epitaxial layer (11) is formed. The dimension of the isolation region is, however, not dependent upon the patterning accuracy of the photoresist film (20), because the window exposing the epitaxial layer is formed in self alignment with the silicon nitride film (first mask). Following the formation of this window, the photoresist film (20) is removed by an organic solvent and, subsequently, an isolation region (16') is formed by diffusion using boron bromide ($BBr_3$) as illustrated in Figure 6. A thick silicon dioxide film again covers the surface of the isolation region. The adhesion of the reaction product of the reaction of boron with the silicon nitride film upon the silicon nitride ($Si_3N_4$) film is extremely small in the present invention as compared with the conventional process, because the width of the silicon nitride film, which covers the outer periphery of all windows, is the minimum value, as explained herein above.

Following the formation of the isolation region, a collector-contact region (17'), a base region (18') and an emitter region (19') are successively formed as illustrated in Figure 7 by repeating photolithography and diffusion steps similar to those in the formation of the isolation region. When the formation of these regions is completed, the silicon nitride ($Si_3N_4$) film is removed. Subsequently, the electrode-contact windows (not shown) of the collector-contact regions (17'), base region (18') and emitter region (19') are formed.

Industrial applicability

The present invention can be applied for the production of a semiconductor integrated circuit, in which a number of semiconductor elements, such as bipolar transistors, are formed.

Table of reference numerals and parts

| | |
|---|---|
| 1 | P type semiconductor substrate |
| 2 | N type epitaxial layer |
| 3 | silicon nitride film |
| 4 | silicon dioxide film |
| 5 | isolation region |
| 10 | P type semiconductor silicon substrate |
| 11 | N type epitaxial layer |
| 12 | silicon dioxide ($SiO_2$) film |
| 12' | second masks |
| 13 | silicon nitride ($Si_3N_4$) film |
| 13' | first masks |
| 16 | window |
| 16' | isolation region |
| 17 | window |
| 17' | collector-contact region |
| 18 | window |
| 18' | base region |
| 19' | emitter region |
| 20 | photoresist film |

**Claims**

1. A process for producing a semiconductor device comprising the steps of:

forming a nitride film over a semiconductor body:

selectively removing said nitride film so as to form first masks made of nitride, each of which masks is in the form of an endless stripe in a plan view;

masking the semiconductor body not covered by said first masks by second masks of an oxide film, the width in the plan view of the stripe of each said first mask being considerably less than the widths of the second masks;

selectively removing said second masks, thereby exposing said semiconductor body, and;

introducing boron impurities into said exposed semiconductor body.

2. A process for producing a semiconductor device according to claim 1, characterized in that, prior to the formation of said nitride film an oxide film is preliminarily formed on said semiconductor body.

3. A process for producing a semiconductor device according to claim 2, characterized in that, subsequently to the selectively removal of said nitride film, said second masks are formed by an oxidation, in which the thickness of said preliminarily formed oxide film not covered by said nitride film becomes sufficient for masking against the boron impurities.

4. A process for producing a semiconductor device according to any one of the preceding claims wherein said nitride film is removed, so that the width of each of said first masks is approximately 4 $\mu$m.

## Patentansprüche

1. Verfahren zur Herstellung einer Halbleitervorrichtung mit den folgenden Schritten:

Bildung eines Nitridfilms über einem Halbleiterkörper,

selektive Entfernung des Nitridfilms, um erste, aus Nitrid hergestellte Masken zu bilden, von denen jede in der Draufsicht die Form eines endlosen Streifens hat,

Maskierung des nicht von den genannten ersten Masken bedeckten Halbleiterkörpers durch zweite Masken aus Oxidfilm, wobei in der Draufsicht die Breite der Streifen von jeder der genannten ersten Masken erheblich kleiner als die Breite der zweiten Masken ist,

selektive Entfernung der genannten zweiten Masken, wodurch der Halbleiterkörper exponiert wird, und

Einführung von Bor-Verunreinigungen in den genannten exponierten Halbleiterkörper.

2. Verfahren zur Herstellung einer Halbleitervorrichtung nach Anspruch 1, dadurch gekennzeichnet, daß vor Bildung des genannten Nitridfilms auf dem genannten Halbleiterkörper vorläufig ein Oxidfilm gebildet wird.

3. Verfahren zur Herstellung einer Halbleitervorrichtung nach Anspruch 2, dadurch gekennzeichnet, daß nach der selektiven Entfernung des genannten Nitridfilms die genannten zweiten Masken durch eine Oxidation gebildet werden, bei welcher die Dicke des nicht durch den genannten Nitridfilm bedeckten vorläufig gebildeten Oxidfilms, für die Maskierung gegen die Bor-Verunreinigungen ausreichend wird.

4. Verfahren zur Herstellung einer Halbleitervorrichtung nach einem der vorhergehenden Ansprüche, bei welchem der genannte Nitridfilm entfernt wird, so daß die Breite jeder der genannten ersten Masken etwa 4 $\mu$m ist.

## Revendications

1. Procédé de production d'un dispositif à semiconducteurs comprenant les opérations suivantes:

— former une pellicule de nitrure au-dessus d'un corps semiconducteur;
— retirer sélectivement ladite pellicule de nitrure de façon à former des premiers masques faits de nitrure, chacun des premiers masques ayant la forme d'une bande sans fin dans une vue en plan;
— masquer le corps semiconducteur non couvert par lesdits premiers masques au moyen de deuxièmes masques d'une pellicule d'oxyde, la largeur de la bande de chaque dit premier masque étant, dans la vue en plan, considérablement inférieure à la largeur des deuxièmes masques;
— enlever sélectivement lesdits deuxièmes masques afin d'exposer ledit corps semiconducteur; et
— introduire des impuretés de bore dans ledit corps semiconducteur exposé.

2. Procédé de production d'un dispositif à semiconducteurs selon la revendication 1, caractérisé en ce que, avant la formation de ladite pellicule de nitrure, on forme préalablement sur ledit corps semiconducteur une pellicule d'oxyde.

3. Procédé de production d'un dispositif à semiconducteurs selon la revendication 2, caractérisé en ce que, à la suite de l'enlèvement sélectif de ladite pellicule de nitrure, on forme un deuxième masque par une oxydation, dans laquelle l'épaisseur de ladite pellicule d'oxyde préalablement formée non couverte par ladite pellicule de nitrure devient suffisante pour agir comme masque contre les impuretés de bore.

4. Procédé de production d'un dispositif à semiconducteurs selon l'une quelconque des revendications précédentes, où on retire ladite pellicule de nitrure de façon que la largeur de chacun desdits premiers masques ait environ 4 $\mu$m.

Fig. 1

Fig. 2

Fig. 3

Fig. 4

1

## Fig. 5

## Fig. 6

## Fig. 7